# EUROPEAN PATENT APPLICATION

(11) **EP 2 219 261 A1**
(43) Date of publication of application: **18.08.2010**
(21) Application number: 09819262.8
(22) Date of filing: 09.10.2009
(51) Int. Cl.: H01M 14/00, H01L 31/04, H01M 2/08

(54) **FUNCTIONAL DEVICE AND MANUFACTURING METHOD THEREFOR**

(30) Priority: 09.10.2008 JP 2008262824
(71) Applicant: Sony Corporation, Tokyo 108-0075 (JP)
(72) Inventor: YONEYA Reiko, Tokyo 108-0075 (JP); ORIHASHI Masaki, Tokyo 108-0075 (JP); MOROOKA Masahiro, Tokyo 108-0075 (JP); SUZUKI Yusuke, Tokyo 108-0075 (JP)
(74) Representative: Malden, Nicholas
(86) International application number: PCT/JP2009/067598
(87) International publication number: WO 2010/041729

(57) **Abstract**

The present invention relates to a functional device capable of providing a functional device such as a dye-sensitized solar cell or the like, which is capable of maintaining high characteristics, and a method for manufacturing the functional device.

A dye-sensitized solar cell serving as a functional device includes a transparent substrate 12a on which a transparent conductive film 13a is formed; a substrate 12b on which a conductive film 13b is formed; an electrolyte solution 16 filled between the two substrates; an inner main seal 15a composed of a first ultraviolet-curable resin so as to seal the electrolyte solution and bond the two substrates together; and an outer main seal 17a composed of a second ultraviolet-curable resin so as to bond the two substrates together outside the inner main seal. The solar cell includes an end seal plate 19 bonded to the substrate 12b with inner end seals 15b and 15c which are composed of a first ultraviolet-curable resin and which close openings of electrolyte solution injection holes 18a and 18b to seal the electrolyte solution, the electrolyte solution injection holes 18a and 18b being formed in the substrate 16b in order to fill the electrolyte solution, and an outer end seal 17b which is disposed outside the inner end seal and which is composed of a second ultraviolet-curable resin.

## Description

### Technical Field

The present invention relates to a functional device suitable for dye-sensitized solar cells and the like and a method for manufacturing the same, and particularly relates to a technique for sealing functional devices.

### Background Art

Solar cells utilizing solar light have attracted attention as energy sources alternative to fossil fuel and have been variously studied. Solar cells are a type of photoelectric transducer which converts optical energy to electric energy and which has a very small influence on the global environment because solar light is used as an energy source, and thus further popularization is expected.

Dye-sensitized solar cells sensitized with dyes and utilizing photoinduced electron transfer have recently attracted attention as next-generation solar cells alternative to silicon (Si)-based solar cells and the like and have been widely investigated. As sensitizing dyes, materials which can effectively absorb light near visible light, for example, ruthenium complexes and the like, are used. The dye-sensitized solar cells have a high photoelectric conversion efficiency and can be simply produced with high productivity using inexpensive semiconductor materials, such as titanium oxide and the like, without the need for a large-scale production apparatus such as a vacuum device or the like, and are thus expected as next-generation solar cells.

In general, the characteristic that stable photoelectric conversion characteristics are exhibited over a long period of time is given as a characteristic required for solar cells. Dye-sensitized solar cells generally contain a liquid electrolyte component as a constituent element. In order to achieve the stable photoelectric conversion characteristics over a long period of time, a sealing technique for avoiding evaporation or leakage of the electrolyte component and decrease in performance due to entering of moisture, oxygen, and other components into the electrolyte from air, and the like has been an important problem. In order to resolve this problem, various methods have been studied, and, for example, there is the following method.

First, Patent Literature 1 described below and titled "Sealing Material for Dye-Sensitized Solar Cell" has the following description.

A sealing material for dye-sensitized solar cells of the invention of Patent Literature 1 is a sealing material to be interposed between two opposed electrode substrates in order to form a space in which an electrolyte solution is sealed between the two electrode substrates, the sealing material being configured to include an electrolyte solution-resistant layer in contact with the electrolyte solution and a gas-permeation-resistant layer provided in contact with the electrolyte solution-resistant layer, the electrolyte solution-resistant layer being formed using a fluorocarbon polymer, and the gas-permeation-resistant layer being formed using at least one selected from the group consisting of polyvinylidene chloride (PVDC), ethylene-vinyl alcohol copolymers (EvOH), and polyvinyl alcohol (PVA).

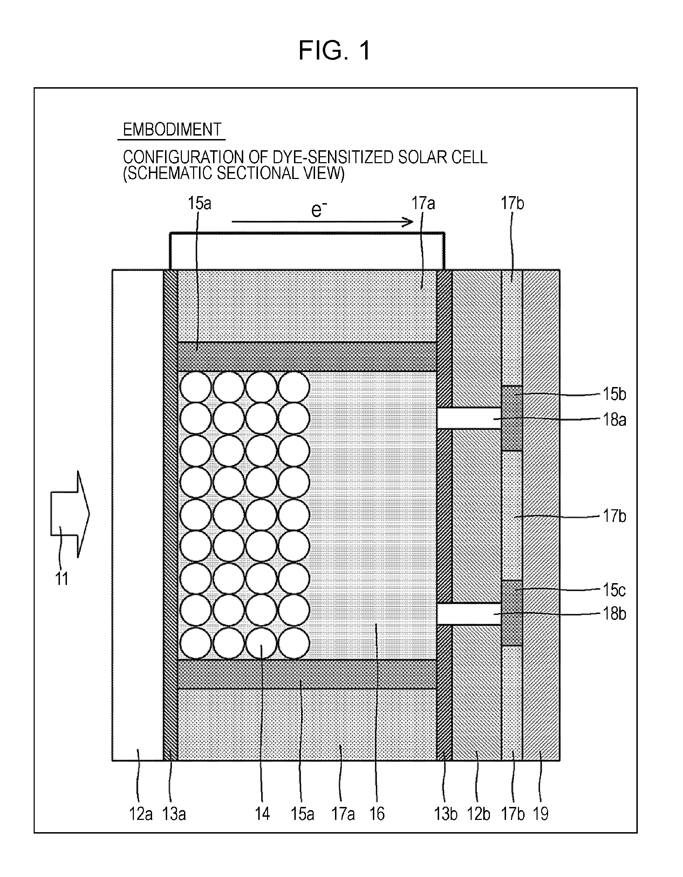

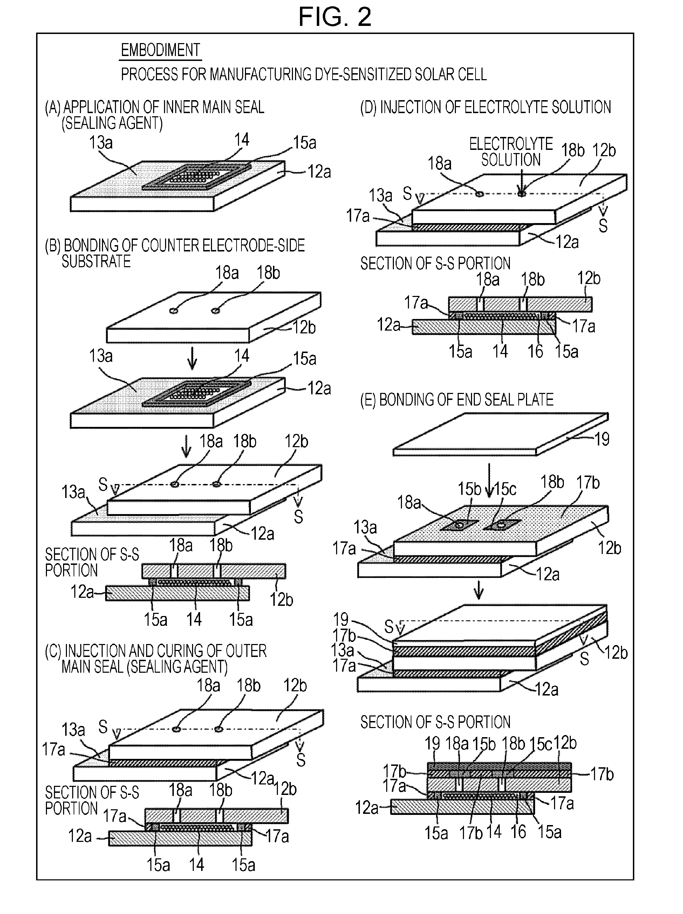

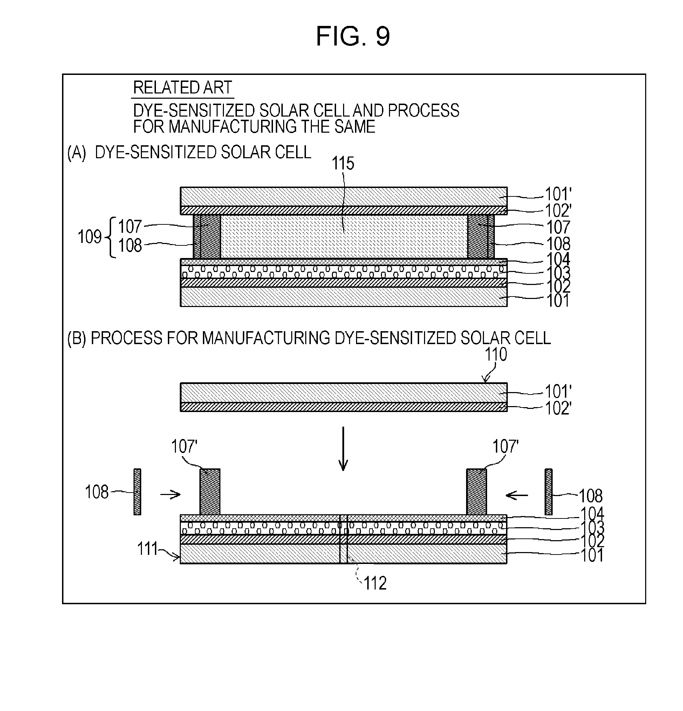

Fig. 9 corresponds to Figs. 1 and 2 described in Patent Literature 1, in which Fig. 9(A) is a sectional view showing an example of a dye-sensitized solar cell using a sealing material for dye-sensitized solar cells, and Fig. 9(B) is a sectional view showing a process for manufacturing a dye-sensitized solar cell.

As shown in Fig. 9(A), a sealing material for dye-sensitized solar cells of the invention of Patent Literature 1 (hereinafter abbreviated as a "sealing material") 9 is provided with an electrolyte solution-resistant layer 107 and a gas-permeation-resistant layer 108 provided in contact with the electrolyte solution-resistant layer 107. The sealing material is **characterized in that** the electrolyte solution-resistant layer 107 is formed using a fluorocarbon polymer, and the gas-permeation-resistant layer 8 is formed using at least one selected from the group consisting of PVDC, EvOH, and PVA.

The sealing material 109 is usually used in a form as shown in Fig. 9(A). In addition, in Fig. 9(A), reference numerals 101 and 101' each denote a transparent substrate composed of glass or the like, reference numerals 102 and 102' each denote a transparent conductive film, reference numeral 103 denotes a porous film, reference numeral 104 denotes a sensitizing dye, and reference numeral 15 denotes an electrolyte solution.

Here, the dye-sensitized solar cell shown in Fig. 9(A) can be formed, for example, as follows. Namely, as shown in Fig. 9(B), first, an electrode substrate 111 serving as an anode is formed by forming the transparent conductive film 102 on one of the surfaces of the transparent substrate 101, uniformly applying titanium oxide particles on the transparent conductive film 102 and heating the particles to provide the porous film 103, and further adsorbing the sensitizing dye 104 such as a ruthenium complex or the like on the porous film 103, and an electrode substrate 110 serving as a cathode is formed by forming the transparent conductive film 102' on one of the surfaces of the transparent substrate 101' in the same manner as the above.

Then, as shown in the drawing, a composition 107' for forming the electrolyte solution-resistant layer is applied (disposed) in a frame form on the surface of the sensitizing dye 104 on the electrode substrate 111. In addition, in order to enhance adhesion of the composition 107' to the surface of the sensitizing dye 104, it is preferred to appropriately treat the adhesion surface with primer. Then, as shown in the drawing, a sheet (the gas-permeability-resistant layer 108) made of a material such as PVDC, EvOH, or PVA is bonded to the peripheral surface of the frame-shaped composition 107', and further the electrode substrate 111 is opposed to the electrode substrate 110 as shown in the drawing and bonded thereto with the frame-shaped composition 107' provided between both substrates to form a closed space by both substrates and the frame-shape composition 107'. Then, the composition 107' is vulcanized by heating (generally 80°C to 150°C for 30 to 60 minutes). Then, the electrolyte solution 115 is injected from an injection hole 112 bored in the electrode substrate 110, and then the injection hole 112 is closed to obtain a dye-sensitized solar cell as shown in Fig. 9(A).

Also, in Patent Literature 2 described below and titled "Dye-Sensitized Solar Cell Module", it is described that an ultraviolet curable sealing material (31X-101 manufactured by Three Bond Co., Ltd.) is applied to an electrolyte solution injection hole and cured.

### Citation List

### Patent Literature

PTL 1: Japanese Unexamined Patent Application Publication No. 2007-294387 (paragraphs 0010 to 0011, paragraphs 0017 to 0018, paragraphs 0043 to 0044, Fig. 1, and Fig. 2)
PTL 2: Japanese Unexamined Patent Application Publication No. 2007-220606 (paragraphs 0017 to 0022, paragraphs 0101 to 0102, Fig. 1, and Fig. 2)

### Summary of Invention

### Technical Problem

The life of a functional device represented by a dye-sensitized solar cell configured as a wet device is greatly influenced by a sealing technique. In many wet devices in which a liquid is injected in a space between opposed substrates, generally, the peripheries of the devices are sealed (main seal) before liquid injection, and then the liquid is injected from injection holes separately provided.

The sealing of the peripheries can be performed before the liquid is injected into the space, and a sealing agent is cured in a state without direct contact with the liquid, and thus if the cured sealing agent has low permeability to the liquid and resistance, the liquid can be sealed over a long time, thereby exhibiting high sealing performance. On the other hand, final sealing (so-called end seal) of the injection hole after the liquid is injected into the space has the problem of significantly decreasing adhesive strength due to contact between the liquid injected into the space and the sealing agent before curing near the injection hole.

In addition, there have been no report of a functional device structure such as a solar cell or the like having a double sealing structure using two types of different ultraviolet-curable resins.

The present invention has been achieved for solving the above-described problem and an object of the invention is to provide a functional device having high barrier property and durability and being capable of stably operating while maintaining high characteristics over a long period of time, and to provide a method for manufacturing the device. Solution to Problem

That is, the present invention relates to a functional device including a first substrate (for example, a photoelectrode-side transparent substrate 12a in an embodiment described below) on which a first conductive electrode (for example, a photoelectrode-side transparent conductive film 13a in an embodiment described below) is formed, a second substrate (for example, a counter electrode-side substrate 12b in an embodiment described below) on which a second conductive electrode (for example, a counter electrode-side conductive film 13b in an embodiment described below) is formed, a functional material (for example, an electrolyte solution 16 in an embodiment described below) filled between the first substrate and the second substrate, a first seal portion (for example, an inner main seal 15a in an embodiment described below) composed of a first ultraviolet-curable resin and disposed between the first substrate and the second substrate to seal the functional material and bond together the first substrate and the second substrate, and a second seal portion (for example, an outer main seal 17a in an embodiment described below) composed of a second ultraviolet-curable resin and disposed between the first substrate and the second substrate to bond together the first substrate and the second substrate outside the first seal portion.

Also, the present invention relates to a method for manufacturing a functional device including a first step of applying a first ultraviolet-curable resin in a ring shape to a surface of a first substrate (for example, a photoelectrode-side transparent substrate 12a in an embodiment described below) on which a first conductive electrode (for example, a photoelectrode-side transparent conductive film 13a in an embodiment described below) is formed, a second step of opposing a second substrate (for example, a counter electrode-side substrate 12b in an embodiment described below) on which a second conductive electrode (for example, a counter electrode-side conductive film 13b in an embodiment described below) is formed to the first substrate and bonding together the first substrate and the second substrate through a ring-shaped first seal portion (for example, an inner main seal 15a in an embodiment described below) formed by curing the first ultraviolet-curable resin, a third step of forming a second seal portion (for example, an outer main seal 17a in an embodiment described below) by filling and curing a second ultraviolet-curable resin filled between the first substrate and the second substrate outside the first seal portion and bonding together the first substrate and the second substrate, a fourth step of filling an inner space formed by the first and second substrates and the first seal portion with a functional material (for example, an electrolyte solution 16 in an embodiment described below) from an opening (electrolyte solution injection holes 18a and 18b in an embodiment described below) provided in the first substrate, and a fifth step of sealing the opening. Advantageous Effects of Invention

According to the present, the functional material is sealed by forming a double sealing structure main seal, which is composed of ultraviolet-curable resins, using the first seal portion formed between the first substrate and the second substrate and the second seal portion formed outside the first seal portion, and thus leakage of the functional material to the outside can be prevented and the functional material can be shielded from the outside atmosphere, thereby providing a functional device having high barrier property and good durability and being capable of stably operating while maintaining characteristics over a long period of time.

Also, according to the present invention, a first ultraviolet-curable resin is applied in a ring shape to a surface of the first substrate, the second substrate is opposed to the first substrate and both substrates are bonded together with a ring-shaped first seal portion formed by curing the first ultraviolet-curable resin, a second seal portion is formed by filling a second ultraviolet-curable resin between the first substrate and the second substrate and curing the resin, both substrates are bonded together, an inner space formed by both substrates and the first seal portion is filled with a functional material from an opening provided in the first substrate, and the opening is sealed to seal the functional material in the inner space, thereby sealing the functional material by forming a double sealing structure main seal composed of ultraviolet-curable resins using the first seal portion and the second seal portion formed outside the first seal portion. Therefore, leakage of the functional material to the outside can be prevented and the functional material can be shielded from the outside atmosphere, thereby providing a method for manufacturing a functional device having high barrier property and good durability and being capable of stably operating while maintaining characteristics over a long period of time.

### Brief Description of Drawings

[Fig. 1] Fig. 1 is a sectional view schematically showing a configuration example of a dye-sensitized solar cell according to an embodiment of the present invention.
[Fig. 2] Fig. 2 is a drawing illustrating an example of a process for manufacturing a dye-sensitized solar cell according to an embodiment of the present invention.
[Fig. 3] Fig. 3 is a drawing showing an example of a sensitizing dye in an example of the present invention.
[Fig. 4] Fig. 4 is a drawing showing a composition example of an electrolyte solution in an example of the present invention.
[Fig. 5] Fig. 5 is a drawing showing a configuration example of a dye-sensitized solar cell in an example of the present invention.
[Fig. 6] Fig. 6 is a drawing showing a sealing structure of a dye-sensitized solar cell in an example of the present invention.
[Fig. 7] Fig. 7 is a drawing showing a relation between the sealing structures shown in Fig. 6 and characteristic deterioration of dye-sensitized solar cells in an example of the present invention.
[Fig. 8] Fig. 8 is a graph of the data shown in Fig. 7 in an example of the present invention.
[Fig. 9] Fig. 9 is a drawing illustrating a dye-sensitized solar cell of related art.

### Description of Embodiments

A functional device of the present invention is preferably configured to include an opening formed in the second substrate in order to fill the functional material between the first substrate and the second substrate, a third seal portion made of a third ultraviolet-curable resin and formed to close at least the opening and seal the functional material, a fourth seal portion made of a fourth ultraviolet-curable resin and disposed outside the third seal portion, and a third substrate bonded to the second substrate with the third seal portion and the fourth seal portion. According to this configuration, the third substrate is bonded to the second substrate with the third seal portion formed to close at least the opening and the fourth seal portion formed outside the third seal portion, and the functional material is sealed by forming a double-sealing structure end seal composed of ultraviolet-curable resins so that the main seal and the end seal can prevent leakage of the functional material to the outside and can shield the functional material from the outside atmosphere, thereby providing a functional device having high barrier property and good durability and being capable of stably operating while maintaining characteristics over a long period of time.

In addition, preferred is a configuration in which the first ultraviolet-curable resin has low permeability to the functional material, the second ultraviolet-curable resin has lower permeability to water, oxygen, and organic solvents than that of the first ultraviolet-curable resin so that the first seal portion and the second seal portion can prevent leakage of the functional material to the outside and shield the functional material from the outside atmosphere. According to this configuration, the first ultraviolet-curable resin is not decomposed or changed in properties even when coming in contact with the functional material after curing, has low permeability to the functional material, and can prevent leakage of the functional material, and the second ultraviolet-curable resin has lower permeability to water, oxygen, and organic solvents than that of the first ultraviolet-curable resin after curing so that the first seal portion and the second seal portion prevent leakage of the functional material to the outside and form a barrier for shielding from the outside atmosphere, thereby providing a functional device having good durability and being capable of stably operating while maintaining characteristics over a long period of time.

In addition, preferred is a configuration in which the first ultraviolet-curable resin and the third ultraviolet-curable resin are the same, and the second ultraviolet-curable resin and the fourth ultraviolet-curable resin are the same. According to this configuration, the main seal and the end seal can be formed using two types of different ultraviolet-curable resins.

In addition, preferred is a configuration as a device in which the first substrate is composed of a light-transmitting material and which has a photoelectric conversion function, a light control function, or an image display function. According to this configuration, it is possible to realize a cell having a photoelectric conversion function that light incident from the first substrate side can be photoelectrically converted and output as a current to the outside, a functional device such as a light sensor or the like, a functional device such as a liquid crystal device or the like having a light control function that light transmittance can be controlled, or a functional device such as an organic electroluminescence element or the like having an image display function that color development is controlled.

In addition, preferred is a configuration as a dye-sensitized photoelectric transducer which includes a semiconductor electrode layer formed on a surface of the first conductive electrode and holding a sensitizing dye, and an electrolyte solution as the functional material filled between the first substrate and the second substrate so that electrons of the sensitizing dye excited by light absorption are taken to the semiconductor electrode layer and the sensitizing dye, which loses electrons, is reduced with a reducing agent in the electrolyte solution. According to this configuration, it is possible to realize a functional device in which light incident from the first substrate side can be photoelectrically converted with a high conversion efficiency and output as a current to the outside.

A method for manufacturing a functional device of the present invention is preferably configured to include the fifth step including a step of forming a third seal portion by applying and curing a third ultraviolet-curable resin to close at least the opening and seal the functional material and bonding together the third substrate and the second substrate, and a step of forming a fourth seal portion by filling and curing a fourth ultraviolet-curable resin between the second substrate and the third substrate outside the third seal portion and bonding together the second substrate and the third substrate. According to this configuration, the third substrate is bonded to the second substrate with the third seal portion formed to close at least the opening, the second substrate and the third substrate are bonded together by the fourth seal portion outside the third seal portion, and the functional material is sealed by forming a double-sealing structure end seal composed of ultraviolet-curable resins. Therefore, the main seal and the end seal can prevent leakage of the functional material to the outside and can shield the functional material from the outside atmosphere, thereby providing a method for manufacturing a functional device having high barrier property and good durability and being capable of stably operating while maintaining characteristics over a long period of time.

In addition, preferred is a configuration in which the first ultraviolet-curable resin has low permeability to the functional material, and the second ultraviolet-curable resin has lower permeability to water, oxygen, and organic solvents than that of the first ultraviolet-curable resin so that the first seal portion and the second seal portion prevent leakage of the functional material to the outside and shield the functional material from the outside atmosphere. According to this configuration, the first ultraviolet-curable resin is not decomposed or changed in properties even when coming in contact with the functional material after curing, has low permeability to the functional material, and can prevent leakage of the functional material, and the second ultraviolet-curable resin has lower permeability to water, oxygen, and organic solvents than that of the first ultraviolet-curable resin after curding so that the first seal portion and the second seal portion prevent leakage of the functional material to the outside and form a barrier for shielding from the outside atmosphere, thereby providing a method for manufacturing a functional device having good durability and being capable of stably operating while maintaining characteristics over a long period of time.

In addition, preferred is a configuration in which the first ultraviolet-curable resin and the third ultraviolet-curable resin are the same, and the second ultraviolet-curable resin and the fourth ultraviolet-curable resin are the same. According to this configuration, the main seal and the end seal can be formed using two types of different ultraviolet-curable resins.

In addition, preferred is a configuration as a dye-sensitized photoelectric transducer in which the first substrate is composed of a light-transmitting material, the method includes a step of forming a semiconductor electrode layer, which holds a sensitizing dye, on a surface of the first conductive electrode, and an electrolyte solution is filled as the functional material between the first substrate and the second substrate so that electrons of the sensitizing dye excited by light absorption are taken to the semiconductor electrode layer and the sensitizing dye, which loses electrons, is reduced with a reducing agent in the electrolyte solution. According to this configuration, it is possible to realize a method for manufacturing a functional device in which light incident from the first substrate side can be photoelectrically converted with high conversion efficiency and output as a current to the outside.

The functional device of the present invention has two substrates on each of which a conductive electrode is formed so that a functional material is shielded from the outside atmosphere and sealed between both substrates, and also has a double-sealing structure formed by ultraviolet-curable sealing agents having different properties.

For the ultraviolet-curable sealing agent (main sealing agent) used for forming the inner main seal and the inner end seal of a portion in contact with the functional material which is sealed between the two substrates, an ultraviolet-curable sealing agent (main sealing agent) is selected and used so that the functional material does not function as a polymerization inhibitor, thereby preventing decrease in bonding strength between the two substrates and leakage of the functional material.

In addition, the outer main seal and the outer end seal, which have lower permeability to oxygen, water, organic solvents, and the like than that of the inner seals, are formed outside the inner main seal and the inner end seals using an ultraviolet-curable sealing agent (sub-sealing agent), thereby preventing leakage of the functional material and preventing entering of oxygen, water, and the like from the outer atmosphere into the inner space in which the functional material is sealed. As a result, it is possible to realize a functional device having excellent durability and being capable of maintaining characteristics over a long period of time.

In the present invention, the functional material is sealed by the double-sealing structure using ultraviolet-curable sealing agents (sealing agents) having different characteristics, thereby imparting durability and making it possible to form a functional device having excellent durability according to operating environment and resistance properties.

An embodiment of the present invention is described in detail below by taking a dye-sensitized photoelectric transducer (dye-sensitized solar cell) as an example of functional devices with reference to the drawings.

### <Embodiment>

### [Configuration example of dye-sensitized solar cell]

Fig. 1 is a sectional view schematically showing a configuration example of a dye-sensitized solar cell according to an embodiment of the present invention.

A dye-sensitized solar cell (hereinafter may be referred to as "DSC") is described in brief. DSC is configured by a photoelectrode disposed on a side on which solar light 11 is incident, a counter electrode opposed to the photoelectrode 11, and an electrolyte solution 16 held between both electrodes. The photoelectrode is made of a photoelectrode-side transparent conductive film 13a formed on a photoelectrode-side transparent electrode 12a, and a semiconductor porous film 14 of nano-size titanium oxide (TiO₂) which supports a sensitizing dye is formed on the photoelectrode-side transparent conductive film 13a. The sensitizing dye is, for example, a ruthenium bipyridyl complex. The counter electrode is made of a counter electrode-side conductive film 13b formed on a counter electrode-side substrate 12b in which electrolyte solution injection holes 18a and 18b are formed.

A ring-shaped inner main seal portion (first seal portion) is formed on the photoelectrode-side transparent conductive film 13a using an inner main seal (sealing agent composed of an ultraviolet-curable adhesive) 15a so as to surround the porous film 14, the photoelectrode-side transparent substrate 12a and the counter electrode-side substrate 12b are laminated together through the inner seal portion, and the ultraviolet-curable adhesive is cured to bond together the photoelectrode-side transparent substrate 12a and the counter electrode-side substrate 12b.

An outer main seal (a sealing agent composed of an ultraviolet-curable adhesive) 17a is injected from the periphery into the space between the photoelectrode-side transparent substrate 12a and the counter electrode-side substrate 12b, and the ultraviolet-curable adhesive is cured to form an outer main seal portion (second seal portion), thereby bonding together the photoelectrode-side transparent substrate 12a and the counter electrode-side substrate 12b outside the inner main seal 15a.

One of the electrolyte solution injection holes 18a and 18b formed in the counter electrode-side substrate 12b is used as an air vent hole, and the electrolyte solution 16 is injected into the inner space formed by both substrates, i.e., the photoelectrode-side transparent substrate 12a and the counter electrode-side substrate 12b, and the inner main seal 15a from the other of the electrolyte solution injection holes 18a and 18b.

An end seal plate (cover plate) 19 is laminated on the counter electrode-side substrate 12b through inner end seals (a sealing agent composed of an ultraviolet-curable adhesive) 15b and 15c, which are applied to surround the electrolyte solution injection holes 18a and 18b, so as to close at least the electrolyte solution injection holes 18a and 18b, and the ultraviolet-curable adhesive is cured to bond together the counter electrode-side substrate 12b and the end seal plate 19, forming an inner sub-seal portion (third seal portion).

An outer end seal (a sealing agent composed of an ultraviolet-curable adhesive) 17b is injected from the periphery into the space between the counter electrode-side substrate 12b and the end seal plate 19, and the ultraviolet-curable adhesive is cured to bond together the counter electrode-side substrate 12b and the end seal plate 19 outside the inner end seals 15b and 15c, forming an outer sub-seal portion (fourth seal portion).

In this way, the electrolyte solution 16 composed of, for example, a solution prepared by dissolving an iodine-iodine ion redox system in a nitrile solvent, is supported between the photoelectrode-side transparent conductive film 13a and the counter electrode-side conductive film 13b and is supported in the inner space by the inner main seal (sealing agent) 15a, the outer main seal (sealing agent) 17a, the inner end seals 15b and 15c, the outer end seal.

When solar light 11 is applied to a photoelectrode of DSC, electrons in the ground state of a sensitizing dye are excited and transited to an excited state, and the electrons in the excited state are injected into a conduction band of a titanium oxide semiconductor through electric bonding between the sensitizing dye and the titanium oxide semiconductor, reaching the photoelectrode.

On the other hand, the sensitizing dye which loses electrons receives electrons from a reducing agent in an electrolyte solution, for example, iodide ion I⁻, according to the following reaction: 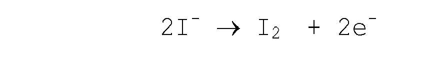 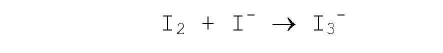 to form an oxidizing agent, for example, triiodide ion I₃⁻ (combination of I₂ and I⁻) in the electrolyte solution. The resulting oxidizing agent reaches a counter electrode due to diffusion and receives electrons from the counter electrode according to reverse reaction of the above reaction 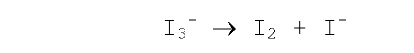 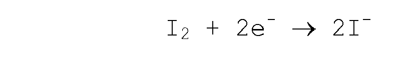 to be reduced to the initial reducing agent.

The electrons transferred from the transparent conductive layer to an external circuit return to the counter electrode after performing electric work in the external circuit. In this way, optical energy is converted to electric energy without leaving any change in the sensitizing dye and the electrolyte solution. This process is repeated to convert light to a current, and thereby electric energy is output to the outside.

As the photoelectrode-side transparent substrate 12a, a substrate having high transmittance in the visible light region, excellent cutoff property for water, various gases such as oxygen, and organic solvents, and excellent solvent resistance and weather resistance is preferred, and examples thereof includes transparent inorganic substrates such as quartz, sapphire, glass, and the like, and transparent plastic substrates such as polyethylene terephthalate, polyethylene naphthalate, polycarbonate, polypropylene, polyphenylene sulfide, polyvinylidene fluoride, polyimide, polysulfone, polyolefin, and the like. These can be used as the counter electrode-side substrate 12b and the end seal plate 19.

As the photoelectrode-side transparent conductive film 13a, for example, an indium-tin compound oxide (ITO), fluorine-doped SnO₂ (FTO), antimony-doped SnO₂ (ATO), SnO₂, and the like can be used.

A semiconductor material which constitutes the semiconductor porous film 14 is preferably an n-type semiconductor material in which conduction band electrons serve as carriers under photoexcitation to produce anode current, and anatase-type titanium oxide TiO₂ is preferred. Besides this, for example, MgO, ZnO, SnO₂, WO₃, Fe₂O₃, In₂O₃, Bi₂O₃, Nb₂O₅, SrTiO₃, BaTiO₃, ZnS, CdS, CdSe, CdTe, PbS, CuInS, InP, and the like can be used.

As the sensitizing dye supported on semiconductor fine particles, a complex with a metal such as ruthenium (Ru), zinc (Zn), platinum (Pt), palladium (Pd), or the like can be used, and a Ru-bipyridine complex compound is particularly preferred because of its high quantum yield. Any other dyes which exhibit a sensitizing function, such as a xanthene dye, a cyanine dye, a porphyrin dye, an anthraquinone dye, a polycyclic quinone dye, and the like, can be used.

The electrolyte solution 16 is prepared by dissolving, in a solvent, at least one oxidation-reduction system (redox pair) which reversibly causes an oxidation/reduction change. Examples of the redox pair include halogens such as I⁻/I₃⁻, Br⁻/Br₂, and the like, pseudo halogens such as quinone/hydroquinone, SCN⁻/(SCN)₂, and the like, iron (II) ion/iron (III) ion, copper (I) ion/copper (II) ion, and the like.

More specifically, for example, a combination of iodine (I₂) and metal iodide or organic iodide or a combination of bromine (Br₂) and metal bromide or organic bromide can be used as an electrolyte. Cation which constitutes a metal halide salt is preferably Li⁺, Na⁺, K⁺, Cs⁺, Mg₂⁺, Ca₂⁺, or the like, and cation which constitutes an organic halide salt is preferably quaternary ammonium ion such as tetraalkylammonium ion, pyridinium ion, imidazolium ion, or the like.

Besides these, a combination of ferrocyanide and ferricyanide, a combination of ferrocene and ferricinium ion, a combination of sodium polysulfide or alkylthiol and alkyl disulfide, and the like can be used as the electrolyte. Among these, an electrolyte prepared by combining iodine (I₂) with lithium iodide (LiI), sodium iodide (NaI), or an imidazolium compound such as imidazolium iodide or the like is preferred.

As the solvent of the electrolyte solution 16, water, various organic solvents, and ionic liquids can be generally used. More specifically, for example, nitrile such as acetonitrile or the like, carbonate such as propylene carbonate, ethylene carbonate, or the like, gamma butyrolactone, pyridine, dimethylacetamide, other polar solvents, an ionic liquid such as methylpropylimidazolium-iodine (MPII) or the like, or a mixture thereof can be used.

In addition, an additive may be added for the purpose of preventing reverse electron transfer in the electrolyte solution and improving the open-circuit voltage and short-circuit current. As the additive, tert-butylpyridine, 1-methoxybenzoimidazole, a carboxylic acid having a long-chain alkyl group having about 13 carbon atoms, or the like can be used.

In addition, an inorganic salt such as lithium iodide, sodium iodide, or the like, or a molten salt such as imidazolium, quaternary ammonium, or the like may be added as a supporting electrolyte to the electrolyte solution.

In addition, a gelling agent, a polymer, a crosslinking monomer, or the like can be dissolved in the electrolyte solution so that the electrolyte solution can be used as a gelled electrolyte composition, and thus leakage and evaporation of the electrolyte composition can be decreased.

The counter electrode-side conductive film 13b is preferably electrochemically stable, and for example, platinum, gold, carbon, conductive polymer, and the like can be used.

As the inner main seal 15a and the inner end seals 15b and 15c, it is preferred to use an ultraviolet-curable resin (adhesive) which causes no change in properties even when coming in contact with the electrolyte solution 16 before and after curing, which causes no decrease in bonding strength after curing and has good iodine resistance, and which can be cured at a low temperature in order to suppress deterioration of the electrolyte solution 16 and the sensitizing dye due to exposure to a high temperature during curing of the sealing resin. Also, it is more preferred that the permeability to the solvent of the electrolyte solution 16, water, and oxygen after curing is low.

As the outer main seal 17a and the outer end seal 17b, an ultraviolet-curable resin (adhesive) (curable at a low temperature) different from the inner main seal 15a and the inner end seals 15b and 15c is used. The outer main seal 17a and the outer end seal 17b have lower permeability to water, oxygen, and organic solvents than that of the inner main seal 15a and the inner end seals 15b and 15c after curing. In addition, the width of the outer main seal 17a is larger than that of the inner main seal 15a so that the outer main seal 17a effectively functions as a barrier to permeation of water, oxygen, and organic solvents. Here, the width of a seal is a dimension in a direction parallel to the surfaces of the substrates 12a and 12b.

As in the above-described sealing structure, use of the inner main seal 15a and the inner end seals 15b and 15c which have good iodine resistance can prevent deterioration of the electrolyte solution 16, and the outer main seal 17a and the outer end seal 17b can suppress leakage of the electrolyte and the solvent of the electrolyte solution 16 and suppress entering of water and oxygen into the electrolyte solution 16 from air, thereby maintaining the performance of DSC and increasing the life.

In addition, the inner main seal 15a and the inner end seals 15b and 15c may be made of different ultraviolet-curable resins (adhesive) as long as they have good iodine resistance after curing. Also, the outer main seal 17a and the outer end seal 17b may be made of different ultraviolet-curable resins (adhesive) as long as they have lower permeability to water, oxygen, and organic solvents than that of the inner main seal 15a and the inner end seals 15b and 15c.

### [Example of process for manufacturing dye-sensitized solar cell]

Fig. 2 includes a perspective view illustrating an example of a process for manufacturing a dye-sensitized solar cell and a sectional view of SS portion according to an embodiment of the present invention.

As shown in Fig. 2, the process for manufacturing a dye-sensitized solar cell includes (A), (B), (C), (D), and (E).

As shown in Fig. 2(A), a photomask is formed on a photoelectrode-side transparent conductive film 13a so as to surround a TiO₂ porous film 14 which supports a sensitizing dye, and an inner main seal (inner main sealing agent) 15a is applied in a ring shape.

As shown in Fig. 2(B), a counter electrode-side substrate 12b and a photoelectrode-side transparent substrate 12a are laminated through the inner main seal 15a so that the conductive films 13a and 13b formed thereon oppose each other, and the inner main seal 15a is cured by ultraviolet irradiation to bond together both substrates 12a and 12b.

As shown in Fig. 2(C), an outer main seal (outer main sealing agent) 17a having low viscosity is injected into a space between the peripheries of the bonded two substrates 12a and 12b using a capillary phenomenon and then cured by ultraviolet irradiation to bond together both substrates 12a and 12b in the peripheries. As a result, an inner space having openings having electrolyte solution injection holes 18a and 18b is formed by the two substrates 12a and 12b and the inner main seal 15a.

As shown in Fig. 2(D), one of the electrolyte solution injection holes 18a and 18b is used as an air vent hole, and an electrolyte solution 16 containing iodine is injected into the inner space from the other of the electrolyte solution injection holes 18a and 18b.

As shown in Fig. 2(E), a photomask is formed on the counter electrode-side substrate 12b, and inner end seals (inner sub-sealing agent) 15b and 15c are applied so as to close at least the openings of the electrolyte solution injection holes 18a and 18b. The inner end seals 15b and 15c may be connected to each other.

Next, an end seal plate 19 is laminated on the counter electrode-side substrate 12 through the inner end seals 15b and 15c, and the inner end seals 15b and 15c are cured by ultraviolet irradiation to bond the counter electrode-side substrate 12 and the end seal plate 19.

Next, the outer end seal (outer sub-sealing agent) 17b having low viscosity is injected in the space between the peripheries of the bonded counter electrode-side substrate 12 and end seal plate 19 using a capillary phenomenon and cured by ultraviolet irradiation to bond together the counter electrode-side substrate 12 and the end seal plate 19 in the peripheries.

As a result, the end seal plate 19 is bonded to the counter electrode-side substrate 12b with the inner end seals 15b and 15c and the outer end seal 17b, and the electrolyte solution injection holes 18a and 18b are sealed to shield the electrolyte solution 16 from the lower atmosphere and seal the electrolyte solution 16 in the inner space.

In addition, as the inner main seal 15a and the inner end seals 15b and 15c, it is preferred to use an ultraviolet-curable resin (adhesive) which cause no change in properties even when combing in contact with the electrolyte solution 16 before and after curing, which causes no decrease in bonding strength after curing, and which has good iodine resistance and low permeability to iodine, and it is more preferred that the permeability to the electrolyte, the solvent, water, and oxygen of the electrolyte solution 16 after curing is low.

In addition, an ultraviolet-curable resin (adhesive) different from the inner main seal 15a and the inner end seals 15b and 15c is used as the outer main seal 17a and the outer end seal 17b. The outer main seal 17a and the outer end seal 17b have lower permeability to water, oxygen, and organic solvents than that of the inner main seal 15a and the inner end seals 15b and 15c after curing.

Further, the inner main seal 15a and the inner end seals 15b and 15c may be made of different ultraviolet-curable resins (adhesive) as long as they have good iodine resistance and low permeability to iodine after curing. In addition, the outer main seal 17a and the outer end seal 17b may be made of different ultraviolet-curable resins (adhesive) as long as they have lower permeability to water, oxygen, and organic solvents than that of the inner main seal 15a and the inner end seals 15b and 15c.

As described above, in the DSC according to this embodiment, an ultraviolet-curable sealing agent (main sealing agent) is selected and used as the ultraviolet-curable sealing agent (main sealing agent) used for forming the inner main seal 15a and the inner end seals 15b and 15c in a portion in contact with the electrolyte solution 16 so that a component contained in the electrolyte solution 16, for example, iodine or the like, does not function as a polymerization inhibitor, thereby preventing decrease in bonding strength and leakage of the electrolyte solution 16.

In addition, the outer main seal 17a and the outer end seal 17b (sub-sealing agent) having lower permeability to water, oxygen, organic solvents, and the like than that of the inner seals are formed by an ultraviolet-curable sealing agent (sub-sealing agent) outside the inner main seal 15a and the inner end seals 15b and 15c, thereby preventing leakage of the solvent and the like of the electrolyte solution 16 and preventing entering of water, oxygen, and the like from the outer atmosphere into the inner space in which the electrolyte solution 16 is sealed.

Summarizing sealing of the electrolyte solution 16, in the DSC according to this embodiment, a resin having iodine resistance and low permeability to iodine is used as an ultraviolet-curable sealing resin for inner seals which forms the inner seals 15a, 15b, and 15c in contact with the electrolyte solution 16.

In addition, a resin having water resistance, oxygen resistance, organic solvent resistance, and low permeability to water, oxygen, and organic solvents is used as an ultraviolet-curable sealing resin for outer seals which forms the outer seals 17a and 17b without contact with the electrolyte solution 16.

In this embodiment, ultraviolet-curable sealing agents (sealing agent) having different properties are used for sealing the electrolyte solution 16 and imparting durability. In this embodiment, DSC having excellent durability can be formed according to operating environment and resistance properties.

This embodiment is not limited to DSC, and the embodiment can be applied to functional devices required to maintain characteristics over a long period of time and each including two substrates on each of which a conductive electrode is formed and a functional material sealed between the two substrates to be shielded from the outer atmosphere, for example, photoelectric transducers (e.g., optical sensor) other than DSC, chemical cells, organic and inorganic electroluminescence elements, display devices using organic or inorganic electroluminescence elements, biosensors, capacitors, and the like.

### <EXAMPLES>

A sealing structure of a dye-sensitized solar cell is described below. A dye-sensitized solar cell was formed according to the manufacturing process shown in Fig. 2.

### [Photoelectrode]

As a photoelectrode including the photoelectrode-side transparent substrate 12a made of a glass plate and the photoelectrode-side transparent conductive film 13a formed as a transparent conductive film on the photoelectrode-side transparent substrate 12a using a FTO material, FTO material (10 Ω) manufactured by Nippon Sheet Glass Co., Ltd. was used.

### [Semiconductor porous film]

Titanium oxide was applied on the FTO layer of the photoelectrode by a screen printing machine and sintered at 510°C for 30 minutes to form a titanium oxide (TiO₂) semiconductor porous film 14 as a semiconductor porous film.

### [Sensitizing dye]

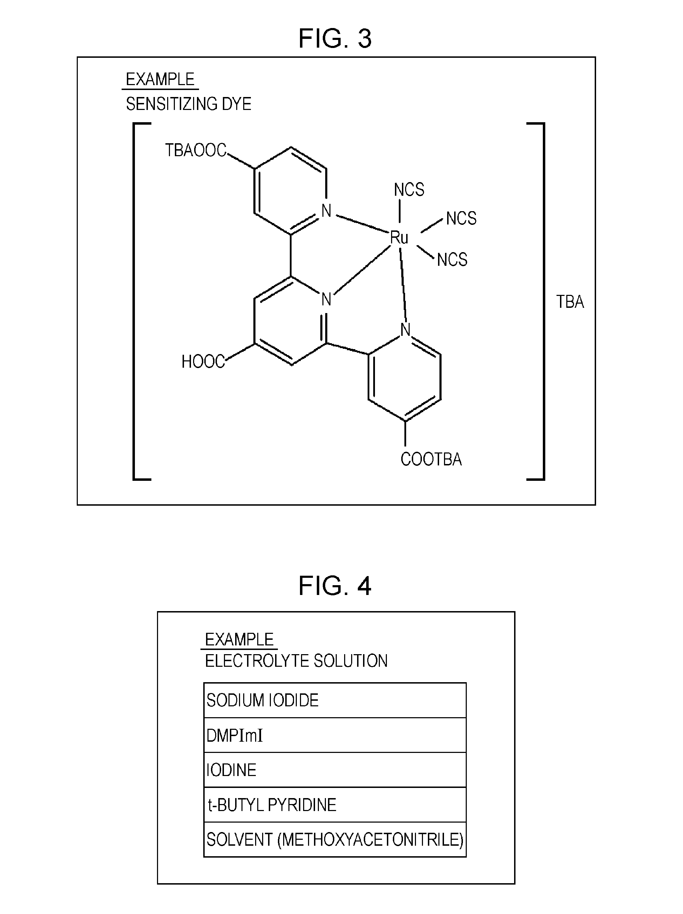

Fig. 3 is a drawing showing an example of a sensitizing dye in an example of the present invention.

As the sensitizing dye, trithiocyanato(4,4',4"-tricarboxy-2,2':6',2"-terpyridine) ruthenium(II) tritetrabutylammonium complex (Ru 620-1H3TBA manufactured by Solaronix Co., Ltd.) (black dye, commonly named N749) was used. This dye is a typical sensitizing dye for dye-sensitized solar cells, which has an absorption peak near visible light (600 nm) and absorption extended to 800 nm (near infrared). In addition, in Fig. 3, TBA represents tetrabutylammonium (N((CH₂)₃CH₃)₄).

The titanium oxide (TiO₂) semiconductor porous film 14 was immersed for 96 hours in a 0.2 mM dye solution containing a mixed solution of t-butanol:acetonitrile = 1:1 as a solvent to support the dye on titanium oxide (TiO₂).

### [Counter electrode]

Glass/Cr/Pt (purchased from Geomatec Corporation) including a glass plate and Cr (thickness 500 Å)/Pt (1000 Å) sputtered thereon was used as a counter electrode in which a counter electrode-side conductive film 13b was formed on a counter electrode-side substrate 12b.

### [Bonding of photoelectrode to counter electrode through inner main seal 15a]

As shown in Fig. 2(A), a photomask was formed on the photoelectrode-side transparent conductive film 13a so as to surround the TiO₂ porous film 14 which supported the sensitizing dye, and an ultraviolet-curable resin (31X-101 resin manufactured by Three Bond Co., Ltd., polybutadiene polymer having methacrylate groups) was used as the inner main seal (inner main sealing agent) 15a and applied in a ring shape.

As shown in Fig. 12(B), the counter electrode-side substrate 12b and the photoelectrode-side transparent substrate 12a were laminated through the inner main seal 15a so that the conductive films 13a and 13b formed thereon opposed each other, and the inner main seal 15a was cured by ultraviolet irradiation to bond both substrates 12a and 12b together.

### [Bonding of photoelectrode to counter electrode through outer main seal 17a]

As shown in Fig. 2(C), an ultraviolet-curable resin having low viscosity (TB3042 manufactured by Three Bond Co., Ltd., one-component solventless radically curable resin) was injected as the outer main seal (outer main sealing agent) 17a into the space between the peripheries of the bonded two substrates 12a and 12b using a capillary phenomenon and then cured by ultraviolet irradiation to bond together both substrates 12a and 12b in the periphery. As a result, an inner space in which the electrolyte solution 16 was sealed was formed by the two substrates 12a and 12b and the inner main seal 15a.

### [Injection of electrolyte solution]

As shown in Fig. 2(D), one of the electrolyte solution injection holes 18a and 18b formed in the counter electrode-side substrate 12b was used as an air vent hole, and the electrolyte solution 16 containing iodine and the like was injected into the inner space from the other of the electrolyte solution injection holes 18a and 18b.

Fig. 4 is a drawing showing a composition example of the electrolyte solution in an example of the present invention.

The electrolyte solution 16 having layers shown in Fig. 4 was injected into the inner space from one of the electrolyte solution injection holes 18a and 18b. In addition, DMPImI shown in Fig. 4 represents 1,2-dimethyl-3-propyl-1H-imidazole-3-ium iodide (C₈H₁₅N₂).

### [Bonding of counter electrode to end seal plate through inner end seals 15b and 15c]

As shown in Fig. 2(E), a photomask was formed on the counter electrode-side substrate 12b, and an ultraviolet-curable resin (31X-101 resin manufactured by Three Bond Co., Ltd.) was used as the inner end seals (inner sub-sealing agent) 15b and 15c and applied so as to close at least the openings of the electrolyte solution injection holes 18a and 18b. In addition, unlike in the example shown in Fig. 2, the inner end seals 15b and 15c were formed to be connected to each other.

Next, the end seal plate 19 was laminated on the counter electrode-side substrate 12 through the inner end seals 15b and 15c, and the inner end seals 15b and 15c were cured by ultraviolet irradiation to bond together the counter electrode-side substrate 12 and the end seal plate 19.

### [Bonding of counter electrode to end seal plate through outer end seal 17b]

Next, as shown in Fig. 2(E), an ultraviolet-curable resin having low viscosity (TB3042 manufactured by Three Bond Co., Ltd.) was injected as the outer end seal (outer main sealing agent) 17b into the space in the periphery of the bonded counter electrode-side substrate 12 and end seal plate 19 using a capillary phenomenon and then cured by ultraviolet irradiation to bond together the counter electrode-side substrate 12 and the end seal plate 19 in the periphery.

As a result, the end seal plate 19 was bonded to the counter electrode-side substrate 12b with the inner end seals 15b and 15c and the outer end seal 17b, and the electrolyte solution injection holes 18a and 18b were sealed to seal the electrolyte solution 16 in the inner space with a shield against the lower atmosphere.

The above-described ultraviolet-curable resin TB3042 (manufactured by Three Bond Co., Ltd.) was cured with ultraviolet light even in the presence of iodine and could be cured even in a state of contact with the electrolyte solution 16 containing iodine. In addition, the above-described ultraviolet-curable resin TB3042 (manufactured by Three Bond Co., Ltd.) was more excellent in water resistance and oxygen resistance than 31X-101 resin and had lower viscosity than 31X-101 resin, and could be easily entered and injected into the narrow space between the two glasses using a capillary phenomenon.

In the DSC of this example, iodine contained in the electrolyte solution 16 did not function as a polymerization inhibitor for the ultraviolet-curable sealing agent (main sealing agent, 31X-101 resin) used for forming the inner main seal 15a and the inner end seals 15b and 15c in a portion in contact with the electrolyte solution 16, thereby preventing decrease in bonding strength and leakage of the electrolyte solution 16. As a commercial ultraviolet-curable sealing agent for which iodine does not serve as a polymerization inhibitor, a resin other than the 31X-101 resin was not found.

In addition, the outer main seal 17a and the outer end seal 17b having more excellent water resistance and oxygen resistance than that of the main sealing agent (31X-101 resin) were made of the sub-sealing agent (TB3042) outside the inner main seal 15a and the inner end seals 15b and 15c, thereby preventing leakage of iodine and the organic solvent constituting the electrolyte solution 16 and preventing entering of water, oxygen, and the like from the outer atmosphere into the inner space in which the electrolyte solution 16 was sealed, maintaining the photoelectric conversion efficiency for a long time, and improving durability.

### [Configuration of dye-sensitized solar cell]

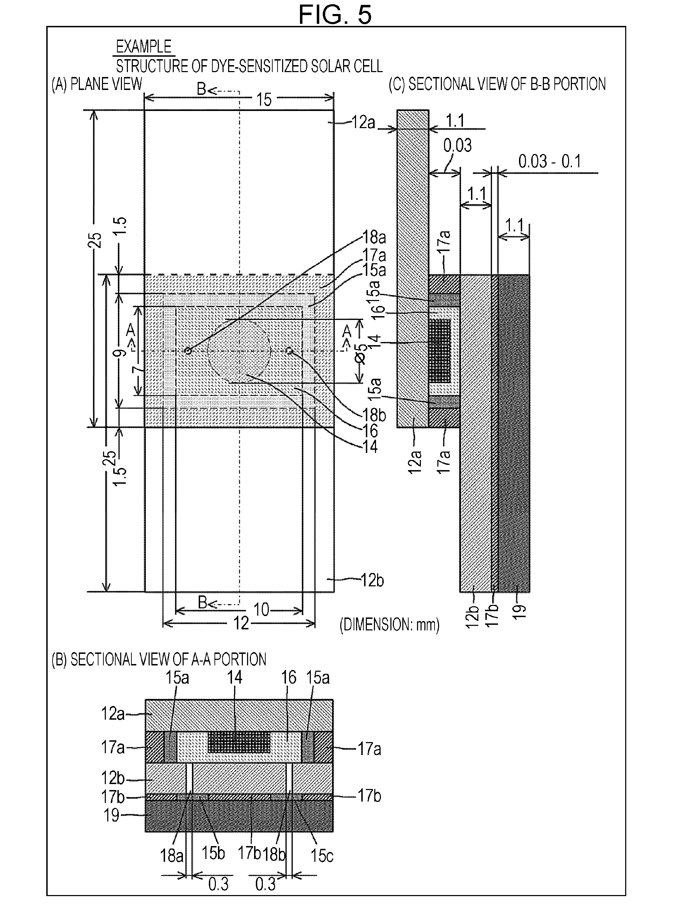

Fig. 5 is a drawing showing a configuration example of a dye-sensitized solar cell in an example of the present invention, in which Fig. 5(A) is a plan view, Fig. 5(B) is a sectional view of A-A portion, and Fig. 5(C) is a sectional view of B-B portion.

Fig. 5 shows the structure and dimensions of the dye-sensitized solar cell formed in the above-described example. The photoelectrode-side conductive film 13a and the counter electrode-side conductive film 13b, which are not shown in the drawing, are exposed to the outside within a region in which the photoelectrode-side transparent substrate 12a and the counter electrode-side substrate 12b are not opposed and bonded to each other, and an external terminal is connected to the exposed portion so that a current produced in the DSC is output to the outside.

The width of the inner main seal 15a is 1 mm, and the width of the outer main seal 17a is 15 mm, and thus the width of the outer main seal 17a is larger than the width of the inner main seal 15a so that the outer main seal 17a effectively functions as a barrier to permeation of water, oxygen, and the organic solvent. Here, the width of a seal is a dimension in a direction parallel to the surfaces of the substrates 12a and 12b.

Although not shown in Fig. 5, the aperture diameter of the electrolyte solution injection holes 18a and 18b is 0.3 mmφ. The end seal plate 19 is composed of a glass plate having low transmissivity, and the end seals 15b, 15c, and 17b are sandwiched between the counter electrode-side substrate 12b and the end seal plate 19 so that leakage in a direction perpendicular to the counter electrode-side substrate 12b is prevented by the end seal plate 19.

### <Comparative Example>

In order to confirm that DSC formed by a main seal and an end seal each having a double-sealing structure using different ultraviolet-curable resins as described above is more excellent than DSC formed by a main seal and an end seal each having a double-sealing structure using a single ultraviolet-curable resin, a comparative example was formed and the durability thereof was compared with DSC of the example by performing an experiment for evaluating characteristic deterioration.

### [Sealing structure]

In description below, an ultraviolet-curable sealing agent (main sealing agent (31X-101 resin, manufactured by Three Bond Co., Ltd.)) is represented by α, and an ultraviolet-curable sealing agent (sub-sealing agent (TB3042, manufactured by Three Bond Co., Ltd.)) is represented by β.

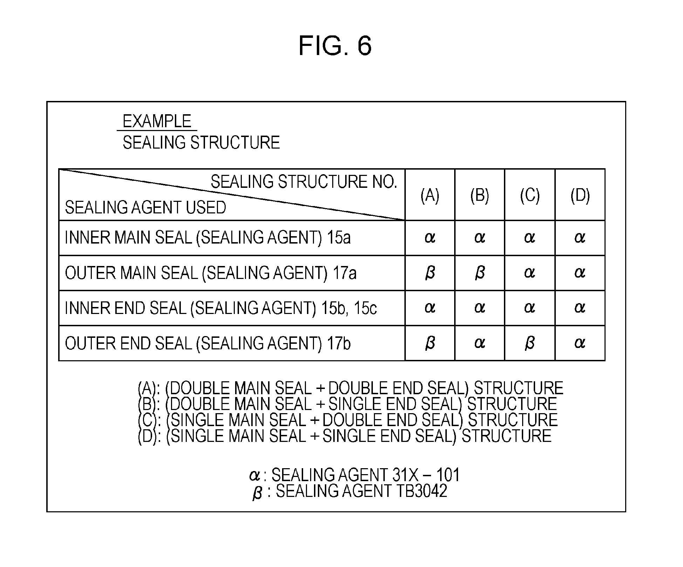

Fig. 6 is a drawing showing an example of a sealing structure of a dye-sensitized solar cell in an example of the present invention.

In Fig. 6, (A) denotes a (double main seal + double end seal) structure, (B) denotes a (double main seal + single end seal) structure, (C) denotes a (single main seal + double end seal) structure, and (D) denotes a (single main seal + single end seal) structure, (A) showing the double-sealing structure in the above-described example, and (B), (C), and (D) each showing a sealing structure of a comparative example.

In the structures (A) and (B) shown in Fig. 6, a main seal has a double sealing structure made of α and β, an inner seal 15a is made of α, and an outer seal 17a is made of β.

In the structures (C) and (D) shown in Fig. 6, a main seal has a single sealing structure made of α, and an inner seal 15a and an outer seal 17a are made of α.

In the structures (A) and (C) shown in Fig. 6, an end seal has a double sealing structure made of α and β, inner seals 15b and 15c are made of α, and an outer seal 17b is made of β.

In the structures (B) and (D) shown in Fig. 6, an end seal has a single sealing structure made of α, and inner seals 15b and 15c and an outer seal 17b are made of α.

### [Relation between sealing structure and characteristic deterioration of dye-sensitized solar cell]

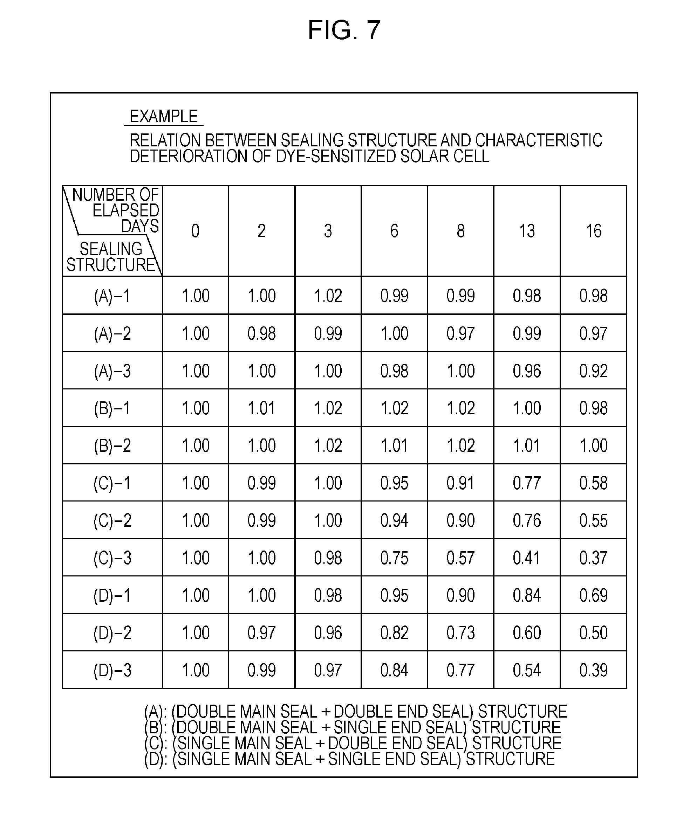

Fig. 7 is a drawing showing a relation between the sealing structures shown in Fig. 6 and characteristic deterioration of dye-sensitized solar cells. In Fig. 7, the characteristic deterioration is shown by the number of days elapsed from the first measurement (number of days elapsed = 0) of the efficiency of photoelectric conversion and the efficiency of photoelectric conversion (%, relative efficiency of photoelectric conversion) obtained by normalizing the efficiency of photoelectric conversion measured after the elapsed days by the efficiency of photoelectric conversion of the first measurement.

In Fig. 7, (A)-1, (A)-2, and (A)-3 each denote a (double main seal + double end seal) structure shown in Fig. 6, (B)-1, (B)-2, and (B)-3 each denote a (double main seal + single end seal) structure shown in Fig. 6, (C)-1, (C)-2, and (C)-3 each denote a (single main seal + double end seal) structure shown in Fig. 6, and (D)-1, (D)-2, and (D)-3 each denote a (single main seal + single end seal) structure shown in Fig. 6.

In the dye-sensitized solar cells formed as described above, the open-circuit voltage (V_{oc}), short-circuit current (J_{sc}), fill factor (ff), and photoelectric conversion efficiency of an I (current) - V (voltage) curve in case of irradiation of pseudo solar light (AM 1.5, 100 mW/cm²) were measured.

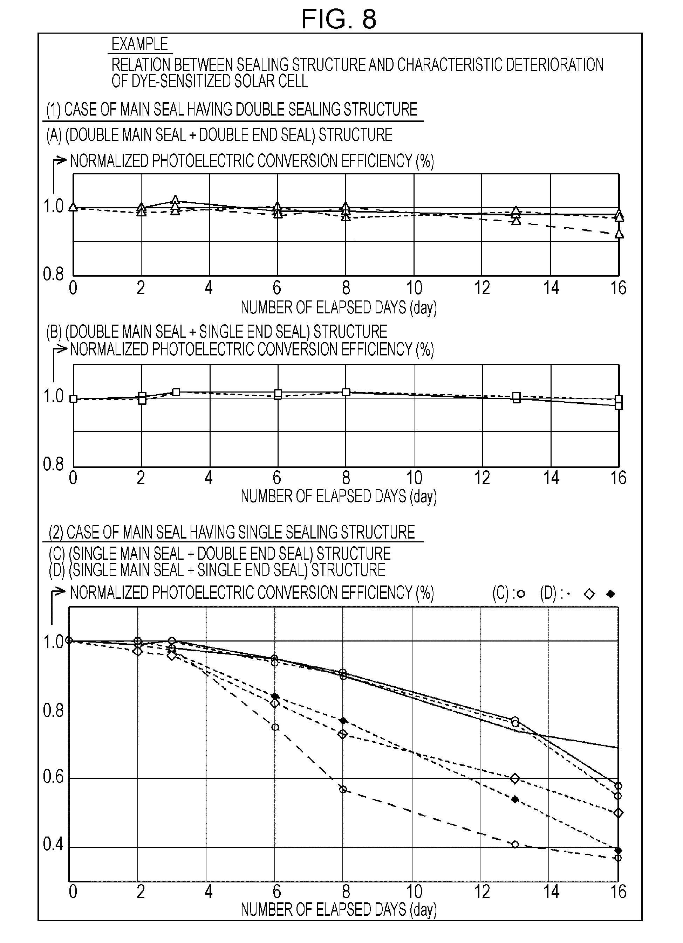

Fig. 8 is a graph of the data shown in Fig. 7, in which Fig. 8(1) shows a main seal having a double sealing structure made of α and β, and Fig. 8(2) shows a main seal having a single sealing structure made of α.

In Fig. 8(1), (A) shows the data of (A)-1, (A)-2, and (A)-3 shown in Fig. 7, and (B) shows the data of (B)-1, (B)-2, and (B)-3 shown in Fig. 7. In Fig. 8(2), (C) shows the data of (C)-1, (C)-2, and (C)-3 shown in Fig. 7, and (D) shows the data of (D)-1, (D)-2, and (D)-3 shown in Fig. 7.

As shown in Fig. 8(1), in the main seal having the double sealing structure made of α and β, substantially no characteristic deterioration is observed, while as shown in Fig. 8(2), in the main seal having the single sealing structure made of α, the characteristic deterioration significantly increases after 3 days have elapsed.

A comparison between Figs. 8(1) and 8(2) indicates that the characteristic deterioration in the main seal having the double sealing structure made of α and β (Fig. 8(1)) is significantly smaller than that in the main seal having the single sealing structure made of α (Fig. 8(2)) and shows that the main seal having the double sealing structure made of α and β is very excellent, and the initial value of photoelectric conversion efficiency is maintained over a long period of time.

The significant characteristic deterioration in the main seal having the single sealing structure made of α indicates that in the main seal having a large contact area with an electrolyte solution and a small distance between the electrolyte solution and the outer atmosphere, the sealing structure made of only α having iodine resistance cannot prevent characteristic deterioration from occurring due to permeation of the organic solvent such as acetonitrile or the like, water, oxygen, and the like.

From this result and substantially no characteristic deterioration in the main seal having the double sealing structure made of α and β, in this double sealing structure, the sealing structure made of β and added to the sealing structure made of α having iodine resistance is considered to significantly suppress the permeation of the organic solvent such as acetonitrile or the like, water, oxygen, and the like and significantly contribute to the prevention of characteristic deterioration.

A comparison between (A) and (B) in Fig. 8(1) indicates that in the case of the main seal having the double sealing structure made of α and β, substantially no difference is observed between the end seal sealing structures, i.e., the double sealing structure made of α and β and the single sealing structure made of α.

Since the end seals have a small contact area with the electrolyte solution and a large distance between the electrolyte solution and the outer atmosphere and the end seals 15b, 15c, and 17b are covered with the end seal plate 19 composed of glass having very low transmittance, the contribution of the end seals to characteristic deterioration possibly depends on the distance between the electrolyte solution and the outer atmosphere rather than the performance of a sealing resin used for the end seals. Therefore, it is thought that in (A) and (B) of Fig. 8(1), substantially no difference in characteristic deterioration is observed between the end seal sealing structures.

In addition, β has higher shielding property for an electrolyte solution component (estimated as methoxyacetonitrile in view of the content) than that of α, rather than the water resistance and oxygen resistance, within the range of the numbers of elapsed days shown in Fig. 7 and 8, and it is thus thought that in (A) and (B) of Fig. 8(1), substantially no difference in characteristic deterioration is observed between the end seal sealing structures.

As seen from the above description, in the example, the inner seals 15a, 15b, and 15c in a portion of contact with the electrolyte solution 16 are formed using an ultraviolet-curable sealing agent (main sealing agent (31X-101 resin)) having iodine resistance in order to seal iodine, and the outer seals 17a and 17b are formed outside the inner seals 15a, 15b, and 15c using an ultraviolet-curable sealing agent (sub-sealing agent (TB3042)) having more excellent water resistance, oxygen resistance, and mechanical strength than the inner seals 15a, 15b, and 15c so that the sealing property can be increased to enhance durability.

Although the present invention is described above with referent to the embodiment and the example, the present invention is not limited to the above-described embodiment and example, and various modifications can be made on the basis of the technical idea of the present invention.

For example, the materials of the substrates 12a and 12b and the end seal substrate 19, the material of the conductive films 13a and 13b, the type of the sensitizing dye, the material of the porous film 1, and the composition of the electrolyte solution 16, which are used in functional devices such as DSC and the like, can be arbitrarily changed according to demand. In addition, ultraviolet-curable sealing resins can be appropriately used as long as the ultraviolet-curable sealing resin for inner seals used for forming the inner seals 15a, 15b, and 15c in contact with the electrolyte solution 16 has iodine resistance, and the ultraviolet-curable resin for outer seals used for forming the outer seals 17a and 17b without contact with the electrolyte solution 16 has water resistance, oxygen resistance, and organic solvent resistance.

### Industrial Applicability

The present invention can provide a functional device such as a dye-sensitized solar cell or the like which has good sealing performance and which is capable of maintaining high efficiency over a long time.

### Reference Signs List

11 ... solar light, 12a ... photoelectrode-side transparent substrate, 12b ... counter electrode-side substrate, 13a ... photoelectrode-side transparent conductive film, 13b ... counter electrode-side conductive film, 14 ... TiO₂ porous film, 15a ... inner main seal, 15b, 15c ... inner end seal, 16 ... electrolyte solution, 17a ... outer mains seal, 17b ... outer end seal, 18a, 18b ... electrolyte solution injection hole, 19 ... end seal plate

## Claims

1. A functional device comprising:
a first substrate on which a first conductive electrode is formed;
a second substrate on which a second conductive electrode is formed;
a functional material filled between the first substrate and the second substrate;
a first seal portion composed of a first ultraviolet-curable resin and disposed between the first substrate and the second substrate to seal the functional material and bond together the first substrate and the second substrate; and
a second seal portion composed of a second ultraviolet-curable resin and disposed between the first substrate and the second substrate to bond together the first substrate and the second substrate outside the first seal portion.

2. The functional device according to Claim 1, comprising an opening formed in the second substrate in order to fill the functional material between the first substrate and the second substrate, a third seal portion composed of a third ultraviolet-curable resin and formed to close at least the opening and seal the functional material, a fourth seal portion composed of a fourth ultraviolet-curable resin and disposed outside the third seal portion, and a third substrate bonded to the second substrate with the third seal portion and the fourth seal portion.

3. The functional device according to Claim 1 or 2, wherein the first ultraviolet-curable resin has low permeability to the functional material, and the second ultraviolet-curable resin has lower permeability to water, oxygen, and an organic solvent than that of the first ultraviolet-curable resin, so that the first seal portion and the second seal portion prevent leakage of the functional material to the outside and shield the functional material from the outside atmosphere.

4. The functional device according to Claim 3, wherein the first ultraviolet-curable resin and the third ultraviolet-curable resin are the same, and the second ultraviolet-curable resin and the fourth ultraviolet-curable resin are the same.

5. The functional device according to Claim 3, wherein the first substrate is composed of a light-transmitting material, and the functional device is configured as a device having a photoelectric conversion function, a light control function, or an image display function.

6. The functional device according to Claim 5, wherein the functional device is configured as a dye-sensitized photoelectric transducer with a photoelectric conversion function which has a semiconductor electrode layer formed on a surface of the first conductive electrode and holding a sensitizing dye, and an electrolyte solution as the functional material filled between the first substrate and the second substrate so that electrons of the sensitizing dye excited by light absorption are taken to the semiconductor electrode layer and the sensitizing dye, which loses electrons, is reduced with a reducing agent in the electrolyte solution.

7. A method for manufacturing a functional device comprising:
a first step of applying a first ultraviolet-curable resin in a ring shape to a surface of a first substrate on which a first conductive electrode is formed;
a second step of opposing a second substrate on which a second conductive electrode is formed to the first substrate and bonding together the first substrate and the second substrate through a ring-shaped first seal portion formed by curing the first ultraviolet-curable resin;
a third step of forming a second seal portion by filling and curing a second ultraviolet-curable resin between the first substrate and the second substrate outside the first seal portion and bonding together the first substrate and the second substrate;
a fourth step of filling an inner space formed by the first and second substrates and the first seal portion with a functional material from an opening provided in the first substrate; and
a fifth step of sealing the opening.

8. The method for manufacturing a functional device according to Claim 7, wherein the fifth step includes a step of forming a third seal portion by applying and curing a third ultraviolet-curable resin to close at least the opening and seal the functional material and bonding together the third substrate and the second substrate, and a step of forming a fourth seal portion by filling and curing a fourth ultraviolet-curable resin between the second substrate and the third substrate outside the third seal portion and bonding together the second substrate and the third substrate.

9. The method for manufacturing a functional device according to Claim 7 or 8, wherein the first ultraviolet-curable resin has low permeability to the functional material, and the second ultraviolet-curable resin has lower permeability to water, oxygen, and an organic solvent than that of the first ultraviolet-curable resin, so that the first seal portion and the second seal portion prevent leakage of the functional material to the outside and shield the functional material from the outside atmosphere.

10. The method for manufacturing a functional device according to Claim 9, wherein the first ultraviolet-curable resin and the third ultraviolet-curable resin are the same, and the second ultraviolet-curable resin and the fourth ultraviolet-curable resin are the same.

11. The method for manufacturing a functional device according to Claim 7 or 8, wherein the first substrate is composed of a light-transmitting material and the method includes a step of forming a semiconductor electrode layer, which holds a sensitizing dye, on a surface of the first conductive electrode so that the functional device is configured as a dye-sensitized photoelectric transducer in which an electrolyte solution as the functional material is filled between the first substrate and the second substrate, electrons of the sensitizing dye excited by light absorption are taken to the semiconductor electrode layer and the sensitizing dye, which loses electrons, is reduced with a reducing agent in the electrolyte solution.
